# EUROPEAN PATENT APPLICATION

(11) **EP 4 756 868 A1**
(43) Date of publication of application: **10.06.2026**
(21) Application number: 24217767.3
(22) Date of filing: 05.12.2024
(51) Int. Cl.: H01L 21/683, H01L 21/268

(54) **METHOD OF LIGHT-INDUCED TRANSFER OF ONE OR MORE COMPONENTS FROM A DONOR SUBSTRATE TO AN ACCEPTOR SUBSTRATE, AND A DONOR SUBSTRATE THEREFOR**

(71) Applicant: Nederlandse Organisatie voor toegepast- natuurwetenschappelijk onderzoek TNO, 2595 DA 's-Gravenhage (NL)
(72) Inventor: The designation of the inventor has not yet been filed
(74) Representative: V.O.

(57) **Abstract**

The present document relates to a method of light-induced transfer of at least one component from a donor substrate to an acceptor substrate. The method comprises providing the donor substrate, wherein the donor substrate comprises an optically transparent carrier for transmitting a light beam. The donor substrate is provided comprising a plurality of release patches on the optically transparent carrier, wherein each release patch is configured for attaching the at least one component to the donor substrate and for releasing the at least one component to the acceptor substrate when the release patch is exposed to optical energy from the light beam. The plurality of release patches are spatially distributed on the transparent carrier, such as to form a release patch array, wherein the donor substrate is further provided comprising a plurality of microlenses at an opposite side of the transparent carrier with respect to the release patch array. The plurality of microlenses form a microlens array for being illuminated with the light beam and for focusing the light beam onto the release patch array, such as to form a plurality of focused beams thereon. The method further comprises illuminating the microlens array with the light beam, wherein optical energy from the focused beams causes a release of attachment of the at least one component to the release patch array, for releasing the at least one component to the acceptor substrate. The present document further relates to a donor substrate for use in said method.

## Description

### Field of the invention

The present invention is directed at a method of light-induced transfer of at least one component from a donor substrate to an acceptor substrate. The method comprises providing the donor substrate, wherein the donor substrate comprises an optically transparent carrier for transmitting a light beam. The donor substrate is provided comprising a plurality of release patches on the optically transparent carrier. Each release patch is configured for attaching the component to the donor substrate, and for releasing the component to the acceptor substrate when exposed to optical energy from the light beam. Furthermore, the present invention is directed at a donor substrate.

### Background

Semiconductor devices and photonics components are extremely fragile, due in part to their small sizes and high aspect ratios. As such, assembly of such devices requires complex pick-and-place equipment to transfer the components without damaging them. This equipment is expensive and intrinsically slow, and at best provides a low transfer yield.

Known transfer techniques are able to transfer small micro-components from a donor substrate to an acceptor substrate. These techniques involve the donor substrate carrying the micro-components using a release stack, which releases a micro-component attached thereto after being illuminated with a light beam that provides sufficient light beam fluence (optical energy delivered per unit of area). However, the required optical power scales with the surface area to be illuminated. Application of this technique is therefore limited to smaller components and cannot freely be applied to handling components of varying sizes.

### Summary of the invention

It is an object of the present invention to provide a method and means that overcome the abovementioned drawbacks, and in particular enable selective and rapid transfer of components of any size, in an energy-efficient and cost-efficient manner.

To this end, in accordance with a first aspect, there is provided herewith a method of light-induced component transfer from a donor substrate to an acceptor substrate, the method comprising: providing the donor substrate, wherein the donor substrate comprises an optically transparent carrier for transmitting a light beam, wherein the donor substrate is provided comprising a plurality of release patches on the optically transparent carrier; and providing, using a light source, the light beam for illuminating the plurality of release patches through the optically transparent carrier; wherein each release patch is configured for attaching the component to the donor substrate and for releasing the component to the acceptor substrate when the release patch is exposed to optical energy from the light beam, wherein the plurality of release patches are spatially distributed on the optically transparent carrier, such as to form a release patch array, wherein the donor substrate is further provided comprising a plurality of microlenses at an opposite side of the optically transparent carrier with respect to the release patch array, the plurality of microlenses forming a microlens array for being illuminated with the light beam and for focusing the light beam onto the release patch array, such as to form a plurality of focused beams thereon, wherein the method further comprises illuminating the microlens array with the light beam from the light source, wherein optical energy from the focused beams causes a release of attachment of the component, for releasing the component to the acceptor substrate.

In the present invention, components are attached to the donor substrate using release patches that cover only a portion of the components' footprints. Release stacks that cover the full footprint of components have bonding strengths far exceeding what is necessary for attaching the components to the donor substrate. A substantial portion of the area to be illuminated of those release stacks is therefore unnecessary for holding the components prior to being illuminated. The present invention removes this unnecessary portion and significantly reduces the area to be illuminated, which greatly reduces the optical power needed to transfer components. Rather than attaching components to the donor substrate using a release stack that covers the full footprint of the components, the method according to the first aspect of the invention instead attaches the components to the donor substrate using a release patch array formed by a plurality of release patches that are spatially distributed across the optically transparent carrier. The components that may be transferred in this manner may thus be much larger than the size of a release stack, which immediately enables the possibility to transfer large components (i.e. components that are much larger than the size of a single release patch). Each release patch may be viewed as equivalent to a small release stack attaching a point or small area of a component's footprint to the donor substrate, with a spacing between all of the release patches. The area to be illuminated is thereby reduced by a factor equal to the ratio of the total component footprint and the total area covered by the release patches. The invention further provides the donor substrate comprising a microlens array. The method according to the first aspect of the invention then involves illuminating the microlens array with a light beam having an intensity and a beam width suitable for release of a specific component or specific components. Each microlens subsequently forms a focused beam onto one of the release patches from the light incident on the microlens. Because the microlenses condense the optical power it receives into a focused beam having a smaller area, the effective intensity of the light used to illuminate the donor substrate is therefore increased. This enables to illuminate the donor substrate with a less power-consuming and less expensive light source emitting a light beam, which yields a light beam fluence that would normally be insufficient for a component to be released. Each focused beam yields a laser fluence sufficient for its respective release patch, ensuring that the component will lose attachment to each release patch after illumination. The method according to the first aspect of the invention thereby enables selective and rapid transfer of components of any size, in an energy-efficient and cost-efficient manner. This method may be applied to many light-induced transfer techniques; the release patches may utilize various processes to facilitate the binding and release of the components. For example, the optical energy may generate heat in the release patches and subsequently initiate a process of de-wetting that causes a loss of adhesion between the components and the donor substrate. Alternatively, the release patches may contain photoresists including for example photoacid generators or photobase generators. The optical energy from the focused beams would then catalyze a chemical reaction changing the solubility of the materials in the release patches in order to facilitate the release of the components to the acceptor substrate. The method according to the first aspect of the invention is therefore highly versatile.

In accordance with some embodiments of the invention, each release patch is formed by a stack of layers comprising: an absorption layer for absorbing optical energy from the light beam, the absorption layer having a first melting temperature; a melting layer for being melted by heat from the absorption layer, the melting layer having a second melting temperature below the first melting temperature; and an adhesive layer for adhering the component to the melting layer, and for releasing the adhesion when the melting layer is in a molten state. The adhesive layer of each release patch in these embodiments typically is composed of polymeric materials, which give the layer a high bonding strength to components. This makes the composition of the release patches according to these embodiments highly suitable for being applied in the invention. The light beam is incident on the microlens array and each microlens focuses its respective portion of the light beam, such that a more converging light beam emerges from each microlens, propagates through the optically transparent carrier, and is focused onto an absorption layer of one of the release patches. In each of the absorption layers, the optical energy of the light beam is then absorbed, such that each absorption layer generates heat therein. Each of the release patches is limited in size, and is consequently surrounded by a gap forming a thermal barrier ensuring that the generated heat substantially remains confined to that respective release patch. The heat in each absorption layer then melts the melting layer of the respective release patch and brings it into a molten, liquid state. The melting temperature of the absorption layer is higher than the melting temperature of the melting layer, such that the absorption layer can remain solid while the melting layer is melted. Once the melting layer is in a molten state, release of the component, which adheres to the release patches via the adhesion layers, occurs via a process of de-wetting. The surface energy of the absorption layer is higher than the surface tension of the molten melting layer. At the same time, the surface tension of the molten melting layer is higher than the surface energy of the adhesion layer. Therefore, when the melting layer of the release patches is molten, adhesion between the absorption layers and melting layers will be maintained, but adhesion between the melting layers and the adhesion layers will be lost, resulting in the release of the component.

In accordance with some embodiments of the invention, each focused beam has a second beam width smaller than a first beam width of the light beam used in the step of illuminating the microlens array, wherein each release patch covers an area on the optically transparent carrier, and wherein a maximum width of the area covered by each release patch relates to the second beam widths such that each focused beam illuminates a major part of the area covered by one of the release patches. The first beam width is the width of the light beam prior to the beam being focused by the microlens array. Thus, in other words, each focused beam exhibits a second beam width, which is narrower than the initial beam width of the light beam applied in the illumination step of the microlens array. Each release patch occupies a defined area on the optically transparent carrier, wherein the maximum width of the area covered by each release patch is proportionate to the second beam widths. This proportion ensures that each focused beam illuminates a substantial portion of the area encompassed by a respective release patch. Substantial in this connection means that at least a major part of the area of the patch is thereby illuminated. The term 'major' is further elaborated upon below. Notably, the first beam width denotes the width of the light beam before it is focused by the microlens array.

The fact that the second beam width is smaller than the first beam width means that the optical energy from the light beam is concentrated into a smaller area, increasing the intensity or optical energy per unit area. This focusing effect allows the energy to be more effective in triggering the release mechanism in the patches, while advantageously requiring a lower overall energy input. Based on the area covered by each release patch, the proportion of each release patch that is exposed to optical energy from a focused beam may vary. All else being equal, a smaller patch area means a greater proportion of the patch will be illuminated by the focused beam, leading to a more efficient use of the optical energy for triggering the release. The area covered by each release patch in combination with the focusing strength of the microlenses may thus be optimized to maximize this energy efficiency.

In accordance with some embodiments of the invention, the major part of the area covered by each release patch that is illuminated by one of the focused beams is at least 50%, preferably at least 80%, more preferably at least 90% of the area covered by each release patch. The method is able to function if the focused beams illuminate a percentage below 100% of the areas covered by the release patches, although the downward deviation from 100% will come with a cost in transfer speed, because some additional time will be needed for the release mechanism to be triggered outside of the illuminated part of the release patches. The closer the percentage is to 100% of the area covered by each release patch, the closer the performance of the method is to optimal performance in terms of energy usage and transfer speed, where optimal performance lies at 100%. In general, the higher the percentage is, the more quickly the components can be transferred, as the release mechanism will be instantaneously triggered in a higher proportion of the release patches. Above 100%, this relation ceases to hold, and although the method would still be able to function in those embodiments, the optical energy of the focused beams is essentially lost energy to the extent that the focused beams illuminated areas outside of the release patches.

In accordance with some embodiments of the invention, prior to illuminating the microlens array, at least one of: multiple release patches adhere a same component to the donor substrate; and multiple release patches adhere a different component to the donor substrate. Multiple release patches may for example hold a single component to the donor substrate, in order to reduce the optical power needed to release that single component to an acceptor substrate. Alternatively however, individual release patches may hold different components to the donor substrate. Illumination of the microlens array in those embodiments then enables to simultaneously release multiple components to the acceptor substrate with a single act of illuminating. This greatly increases the speed with which multiple components may be transferred using the method, thus increasing the throughput that may be achieved with this method in industrial settings. In some other of these embodiments, some release patches may hold a same component to the donor substrate, while at the same time other release patches may each individually hold different components to the donor substrate, or together hold another component to the donor substrate. Any combination of multiple release patches attaching a same component to the donor substrate and individual release patches attaching different components to the donor substrate may be advantageously applied in these embodiments of the invention. Furthermore, these embodiments provide further advantage, because it enables a rapid transfer of multiple components of various sizes and shapes. Some components may have more complex shapes. They may for example be oblong, L-shaped or T-shaped. The release patch array enables to attach such components to the donor substrate 1 at specific points of coverage, and thus removes the need to provide complexly shaped release stacks, or more simply shaped release patches that are larger than the component to be transferred. The area to be illuminated is thereby reduced, improving energy efficiency.

In accordance with some embodiments of the invention, a planar surface of each microlens is one of a group comprising: circular surfaces, elliptical surfaces and polygonal surfaces. The lenses may for example be plano-convex lenses, and the convex surface of each lens may then for example be spherical. Choosing a circular surface as the planar surface of the lens would introduce the fewest design and fabrication complications and uncertainties. In alternative embodiments, the shape of the planar surfaces may be based on the configuration in which the microlenses are placed on the optically transparent carrier. For example, if the microlenses are positioned in a hexagonal lattice, the microlenses may also have circular surfaces, but in alternative embodiments the planar surfaces of the microlenses may be polygonal surfaces. In particular they may be hexagonal surfaces. The combination of a hexagonal lattice and a hexagonal planar surface is an example of an embodiment that maximizes the optical energy that is efficiently utilized in the invention, because in this combination none of the light passes through the optically transparent carrier without entering one of the microlenses. Other combinations, such as square planar surfaces and square lattices, may similarly be chosen to gain this advantage.

In accordance with some embodiments of the invention, each microlens is provided on the optically transparent carrier, such as to be positioned mutually adjacent to each other in one of: a hexagonal lattice, a triangular lattice, a square lattice, a rectangular lattice, a rhombic lattice, a pentagonal lattice, or an oblique lattice. Although in alternative embodiments of the invention, the microlenses may not be positioned to be mutually adjacent to each other, and may instead leave some space in between them, a configuration in which they are contiguous is more advantageous in terms of energy efficiency, because it minimizes the amount of optical energy that is lost because it does not enter any of the microlenses. In some embodiments then, the microlenses may be plano-convex lenses with spherically shaped convex surfaces and circular planar surfaces. In those embodiments, any of the abovementioned lattice geometries may be advantageously applied, but a hexagonal lattice would minimize the size of the areas in between the circular surfaces and thereby minimize the lost optical energy.

In accordance with a second aspect of the invention, there is provided herewith a donor substrate for use in a method according to the first aspect of the invention, for a light-induced component transfer to an acceptor substrate, wherein the donor substrate comprises an optically transparent carrier for transmitting a light beam, wherein the donor substrate comprises a plurality of release patches on the optically transparent carrier, wherein each release patch is configured for attaching a component to the donor substrate and for releasing the component to the acceptor substrate when the release patch is exposed to optical energy from the light beam, wherein the plurality of release patches are spatially distributed on the optically transparent carrier, such as to form a release patch array, wherein the donor substrate further comprises a plurality of microlenses at an opposite side of the optically transparent carrier with respect to the release patch array, for being illuminated with the light beam and for focusing the light beam onto the release patch array, such as to form a focused beam thereon.

The present invention significantly reduces the area on the donor substrate which has to be illuminated in order to set in motion the process of releasing components from the donor substrate to an acceptor substrate, by removing a portion of that area which is unnecessary. Because the donor substrate according to the second aspect of the invention covers only a portion of components' footprints, the optical power necessary to cause release of the components is also reduced, which enables the method according to the first aspect of the invention to be carried out using a light source that emits significantly less optical power and is therefore significantly less expensive. The donor substrate according to the second aspect therefore makes applying the method according to the first aspect of the invention substantially less expensive to perform. This is achieved in the second aspect of the invention by the fact that the donor substrate comprises a release patch array with each of the release patches spatially distributed across a side of the donor substrate and by the fact that the donor substrate further comprises a microlens array on an opposite side of the optically transparent carrier. When applied in the method according to the first aspect of the invention, the microlenses of the microlens array focus the light onto the release patches. Because the microlenses condense the optical power it receives into a focused beam having a smaller area, the effective intensity of the light used to illuminate the donor substrate is therefore increased. The required optical power of the light beam that illuminates the microlens array is therefore reduced, because each focused beam then yields a laser fluence sufficient for its respective release patch, ensuring that the component will lose attachment to each release patch after illumination. The donor substrate according to the second aspect of the invention thereby enables selective and rapid transfer of components of any size, in an energy-efficient and cost-efficient manner. The release patches in the donor substrate may be composed to facilitate various methods of light-induced component transfer. For example, the optical energy may generate heat in the release patches and subsequently initiate a process of de-wetting that causes a loss of adhesion between the components and the donor substrate. Alternatively, the release patches may contain photoresists including for example photoacid generators or photobase generators. The optical energy from the focused beams would then catalyze a chemical reaction changing the solubility of the materials in the release patches in order to facilitate the release of the components to the acceptor substrate. The donor substrate according to the second aspect of the invention is therefore highly versatile.

In accordance with some embodiments of the invention, each release patch is formed by a stack of layers comprising: an absorption layer for absorbing optical energy from the light beam, the absorption layer having a first melting temperature; a melting layer for being melted by heat from the absorption layer, the melting layer having a second melting temperature below the first melting temperature; and an adhesive layer for adhering the component to the melting layer, and for releasing the adhesion when the melting layer is in a molten state. In these embodiments, the adhesive layer of each release patch is typically composed of polymeric materials, providing high bonding strength to the components. This composition makes the release patches particularly well-suited for application in the method according to the first aspect of the invention. Each microlens focuses its respective portion of the light beam onto the absorption layer of one of the release patches, where the optical energy of the focused beam is then absorbed, generating heat within the absorption layer. Each release patch is limited in size, so that they are all surrounded by a gap that forms a thermal barrier that confines the generated heat to the respective patch. The heat in the absorption layer melts the melting layer of the release patch, bringing it into a liquid, molten state. The melting temperature of the absorption layer is higher than that of the melting layer, and consequently the absorption layer remains solid. Once the melting layer is in a molten state, a release of the components, which adhere to the release patches through the adhesion layers, occurs via a de-wetting process. The surface energy of the absorption layer is higher than the surface tension of the molten melting layer, and the surface tension of the molten melting layer is higher than the surface energy of the adhesion layer. As a result, when the melting layer is in a molten state, adhesion between the absorption and melting layers is maintained, but adhesion between the melting and adhesion layers is lost, resulting in the release of the components.

In accordance with some embodiments of the invention, each focused beam has a second beam width smaller than a first beam width of the light beam used in the step of illuminating the microlens array, wherein each release patch covers an area on the optically transparent carrier, and wherein a maximum width of the area covered by each release patch relates to the second beam widths such that each focused beam illuminates a major part of the area covered by one of the release patches. In the donor substrate according to these embodiments, each microlens is shaped to condense the light beam into a focused beam having a second beam width smaller than a first beam width of the light beam. The lenses in that case are positive lenses and may for example be shaped as plano-convex lenses. The magnification of the lenses may then be chosen in combination with the dimension of the optically transparent carrier, such that the focused beams have a second beam width at the release patches for forming spots thereon with a desired spot size. This desired spot size according to these embodiments is a major part of the area covered by a release patch.

In accordance with some embodiments of the invention, the major part of the area covered by each release patch that is illuminated by each respective focused beam is at least 50%, preferably at least 80%, more preferably at least 90% of the area covered by the release patch. Although the donor substrate would be optimally composed in the invention if the shaping of the microlenses and the areas covered by the release patches on the optically transparent carrier yield, in use in the method according to the first aspect of the invention, focused beams that illuminate 100% of the release patches, the donor substrate may deviate from this optimum while still being advantageously applicable in said method. The closer the focusing strength, determined by the shaping of the lens, matches the areas covered by the release patches, the more optimally the donor substrate is composed. A percentage of the areas covered by the release patches that is illuminated by the focused beams, which is higher than 100% will result in a loss in terms of efficient energy usage, while a percentage which is below 100% will result in a loss in transfer speed.

In accordance with some embodiments of the invention, prior to illuminating the microlens array, at least one of: multiple release patches adhere a same component to the donor substrate; and multiple release patches adhere a different component to the donor substrate. In some of these embodiments, multiple release patches may hold a single component to the donor substrate, thereby reducing the optical power required to release that component to the acceptor substrate. Alternatively, individual release patches may hold different components to the donor substrate. In these embodiments, illuminating the microlens array enables the simultaneous release of multiple components to the acceptor substrate with a single illumination, significantly speeding up the transfer process and increasing potential throughput in industrial applications. In other embodiments, some release patches may hold the same component to the donor substrate, while other release patches may individually hold different components or together hold another component to the donor substrate. Any combination of multiple release patches attaching the same component and individual release patches attaching different components can be advantageously used in these embodiments of the invention. Furthermore, these embodiments provide further advantage, because it enables a rapid transfer of multiple components of various sizes and shapes. Some components may have more complex shapes. They may for example be oblong, L-shaped or T-shaped. The release patch array enables to attach such components to the donor substrate 1 at specific points of coverage, and thus removes the need to provide complexly shaped release stacks, or more simply shaped release patches that are larger than the component to be transfered. The area to be illuminated is thereby reduced, improving energy efficiency.

In accordance with some embodiments of the invention, a planar surface of each microlens is one of a group comprising: circular surfaces, elliptical surfaces and polygonal surfaces. The lenses may for example be plano-convex, with spherically shaped convex surfaces. In that case, a circularly shaped planar surface would have the lowest risk of uncertainties in fabrication and may be produced with a more consistent quality. In alternative embodiments, the planar surface shape may correspond to the arrangement of the microlenses on the optically transparent carrier. For example, if the microlenses are arranged in a hexagonal lattice, the planar surfaces may still be circular, but they could also be polygonal in shape. For example, a hexagonal lattice combined with hexagonal planar surfaces would maximize the efficient use of optical energy, as it can ensure that none of the light bypasses the microlenses. Other combinations, such as square planar surfaces within a square lattice, may also be selected to achieve this advantage.

In accordance with some embodiments of the invention, each microlens is provided on the optically transparent carrier, such as to be positioned mutually adjacent to each other in one of: a hexagonal lattice, a triangular lattice, a square lattice, a rectangular lattice, a rhombic lattice, a pentagonal lattice, or an oblique lattice. A contiguous configuration offers greater energy efficiency, as it reduces the amount of optical energy that bypasses the microlenses. In some embodiments, the microlenses may be plano-convex with spherical convex surfaces and circular planar surfaces. While any of the abovementioned lattice geometries may be advantageously applied in these embodiments, a hexagonal lattice would provide additional advantage, as it minimizes the gaps between the circular surfaces, thereby reducing optical energy loss.

In accordance with a third aspect of the invention, there is provided herewith a method of manufacturing a donor substrate according to the second aspect of the invention, wherein the method comprises: providing an optically transparent carrier for transmitting a light beam; spatially distributing a plurality of release patches on the optically transparent carrier, such as to form a release patch array, wherein each release patch is configured for attaching a component to the donor substrate and for releasing the component to an acceptor substrate when the release patch is exposed to optical energy from the light beam; providing an opposite side of the transparent carrier with respect to the release patch array with a plurality of microlenses, such as to form a microlens array for being illuminated with the light beam and for focusing the light beam onto the release patch array, such as to form a plurality of focused beams thereon.

By providing the optically transparent carrier with a plurality of release patches at spatially distributed spots on a side thereof, the present invention greatly reduces the area to be illuminated during the process of releasing components from the donor substrate to an acceptor substrate. The donor substrate manufactured in the method according to the third aspect of the invention is able to carry components with the release patch array which only covers a portion of the components' footprints. This reduces the optical power that is required for releasing the components carried by the donor substrate onto the acceptor substrate. The method according to the first aspect of the invention can then be executed using a light source that emits significantly less optical power and that can therefore be significantly less expensive. When illuminating the microlenses of the donor substrate manufactured according to the third aspect of the invention, each microlens focuses light onto a release patch of the release patch array. These microlenses then increase the effective intensity delivered to each release patch. A light beam having significantly lower overall optical power can therefore be used to trigger the release mechanism of the donor substrate, because each focused beam yields a light beam fluence sufficiently high to activate its designated release patch, ensuring that each component is successfully detached from the release patch. The donor substrate manufactured by the method according to the third aspect allows for a controlled and efficient transfer of components, regardless of size, in an energy-efficient and cost-efficient manner. The method according to the third aspect may involve providing the donor substrate with release patches which support various methods of light-induced component transfer. For example, the optical energy may generate heat in the release patches, which then triggers a de-wetting process that releases adhesion between the components and the donor substrate. In alternative embodiments however, the release patches may include photoresist materials, such as photoacid generators or photobase generators, enabling a chemical reaction upon exposure to focused light. The optical energy from the focused beams would then catalyze a chemical reaction changing the solubility of the materials in the release patches in order to facilitate the release of the components to the acceptor substrate. The method according to the third aspect of the invention therefore provides a high degree of versatility.

### Brief description of the drawings

The invention will further be elucidated by description of some specific embodiments thereof, making reference to the attached drawings. The detailed description provides examples of possible implementations of the invention, but is not to be regarded as describing the only embodiments falling under the scope. The scope of the invention is defined in the claims, and the description is to be regarded as illustrative without being restrictive on the invention. In the drawings:
Figures 1A and 1B schematically illustrate a donor substrate with a component attached to a plurality of release patches, respectively before and after being released from the donor substrate to an acceptor substrate, in accordance with an embodiment of the invention.
Figure 2 schematically illustrates an embodiment of the method in accordance with the first aspect of the invention.
Figures 3A and 3B schematically illustrate a donor substrate with a plurality of components attached to a plurality of release patches, respectively before and after being released from the donor substrate to an acceptor substrate, in accordance with an embodiment of the invention.
Figure 4 schematically illustrates a configuration of a microlens array on a donor substrate in accordance with an embodiment of the invention.
Figures 5A-5C schematically illustrate an embodiment of the method in accordance with the third aspect of the invention.

### Detailed description

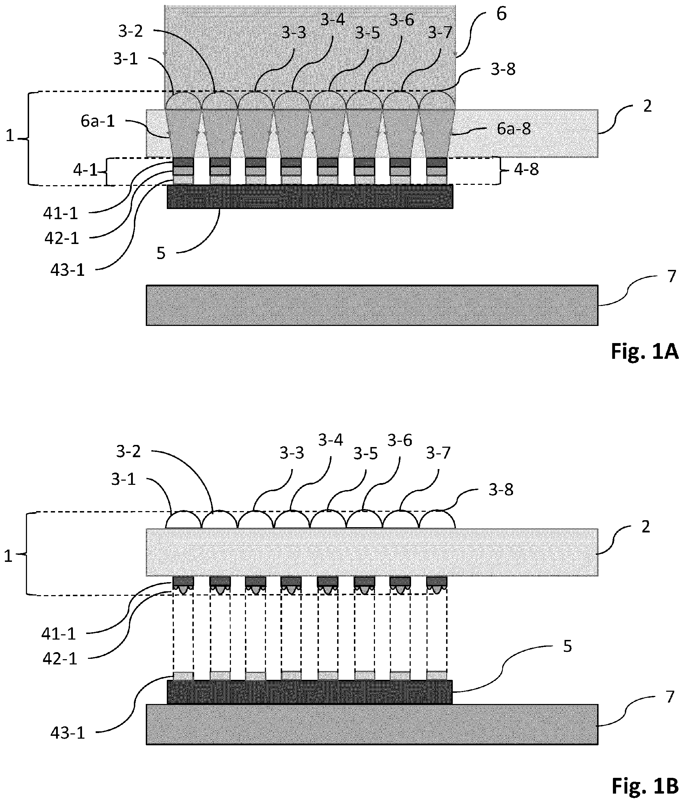

Figure 1A schematically illustrates a donor substrate 1 during use in a method according to the first aspect of the invention. The donor substrate 1 comprises an optically transparent carrier 2. The optically transparent carrier 2 is provided with microlenses 3-1 - 3-8 and corresponding release patches 4-1 - 4-8. In this embodiment, each release patch has an absorption layer 41, a melting layer 42 and an adhesive layer 43 (only the layers 41-1, 42-1 and 43-1 pointed out explicitly in the figure for readability). In alternative embodiments, the release patches may be alternatively composed and may be used to release components to an acceptor substrate through different physical processes than will the release patches illustrated here. For example, the patches may contain photoresists which, upon being exposed to optical energy, catalyze a chemical reaction for facilitating the release of components from the donor substrate to an acceptor substrate. In this embodiment, a component 5 is attached to the adhesive layers 43 of the release patches 4-1 - 4-8. In use, the microlenses 3-1 - 3-8 may be illuminated with a light beam 6. The light beam 6 may be used to illuminate the microlenses 3-1 - 3-8 directly from a light source, but alternatively may be led through beam shaping optics for obtaining a suitable beam shape, such as a collimated light beam. The microlenses 3-1 - 3-8 focus the light beam 6, which propagates through the optically transparent carrier 2 before being incident on the absorption layers 41 of the release patches 4-1 - 4-8.

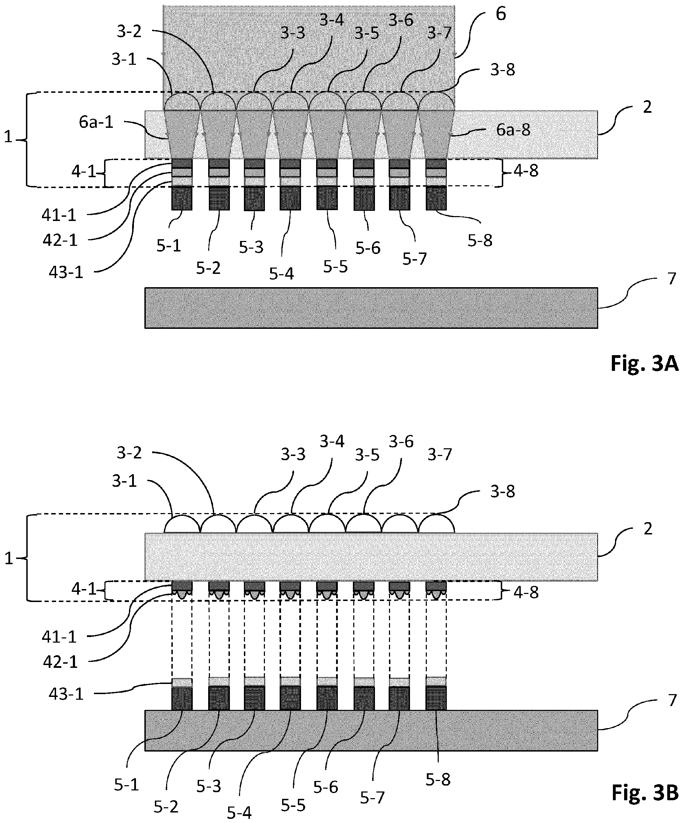

The focused light beams 6a-1 - 6a-8 have beam widths when incident on the absorption layers 41, which may be smaller than the widths of the release patches, such that each focused beam covers only a major part of its respective release patch, such as at least 50%, 80% or 90% of the surface area, as long as the focused beam provides enough light beam fluence to induce the release of the component 5. Alternatively the focused beam may be wide enough to cover the full surface area of the release patches 4-1 - 4-8. The absorption layers 41-1 - 41-8 absorb optical energy from the focused beams 6a-1 - 6a-8 and consequently generate heat. The release patches 4-1 - 4-8 have a confined width, with the air surrounding the release patches forming thermal barriers. The heat generated in the absorption layers 41 thus is conducted to the melting layers 42, which is in direct thermal contact with the absorption layers 41. The melting layers 42 have a melting temperature that is lower than the melting temperature of the absorption layers 41. Therefore, as long as the light beam 6 illuminating the microlenses 3-1 - 3-8 provides sufficiently high light beam fluence to induce the release of the component 5 to the acceptor substrate 7, the melting layers 42 will be melted by the heat conducted from the absorption layers 41, while the absorption layers 41 remain solid. When the melting layers 42, which are typically provided as metallic layers, are in a molten state, the surface tension of the melting layers 42 will be below the surface energy of the absorption layers 41, which are typically also provided as metallic layers, but it will be higher than the surface energy of the typically polymeric adhesive layers 43. As a consequence, de-wetting will occur, wherein adhesion between the absorption layers 41 and the melting layers 42 will be preserved, but adhesion between the melting layers 42 and the adhesion layers 43 will be lost. This will result in the release of the component 5 to the acceptor substrate 7, as shown in figure 1B. The components 5 illustrated in this figure is a large component attached to the donor substrate 1 with release patches 4-1 - 4-8 that cover only a portion of the component's footprint.. Because the large component 5 is held by the donor substrate 1 using a patterned plurality of release patches 4-1 - 4-8, rather than a release stack covering the full footprint of the component 5, the area to be illuminated and therefore the required optical power from the light source for triggering the release of the component 5 to the acceptor substrate 7 is significantly reduced. Upon illumination of the microlens array, the microlenses form the plurality of focused beams 6a-1 - 6a-8. The focused beams are incident on the plurality of release patches 4-1 - 4-8. The absorption layer 41 of each release patch receives the optical energy from the beam 6a focused thereon and consequently generates heat. The gaps between the release patches 4-1 - 4-8 form thermal barriers, forcing the heat generated in each absorption layer 41 to be conducted into the melting layer 42 of the same release patch 4. The melting layer 42 in each release patch 4 reaches its melting temperature and enters a molten state. Once the melting layers 42 are in a molten state, de-wetting occurs, causing each release patch 4 to lose adhesion with the component 5, allowing the component 5 to be released onto the acceptor substrate 7, as shown in figure 3B.

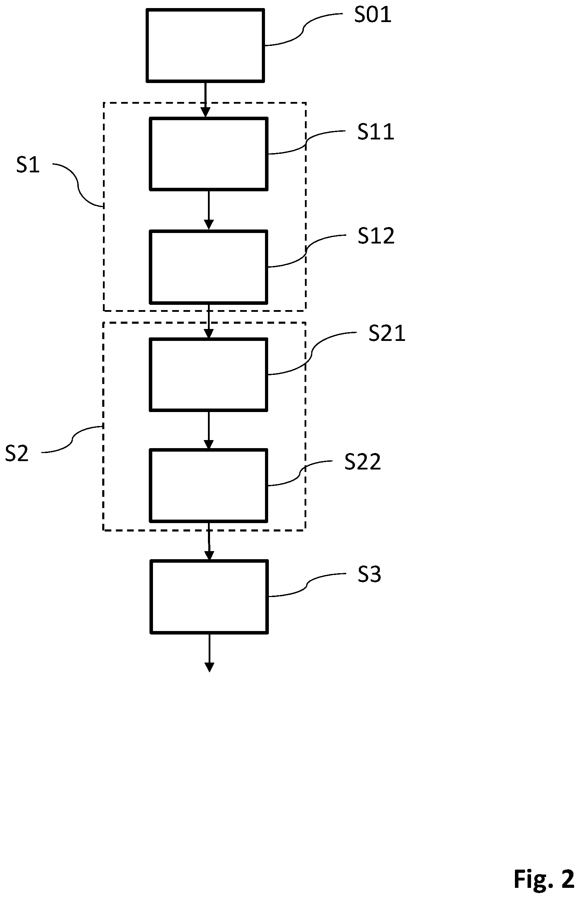

Figure 2 schematically illustrates an embodiment of the method in accordance with the first aspect of the invention. The method involves a step S01 of providing the donor substrate 1. The donor substrate 1 is provided with a plurality of release patches on the optically transparent carrier 2. Furthermore, the donor substrate is provided with a plurality of microlenses 3 at an opposite side of the optically transparent carrier 2 with respect to the release patches. Before release of a component 5 from a donor substrate 1 to an acceptor substrate 7 can begin, it may be that the component 5 first has to be attached to the donor substrate 1. In that case, the method first comprises a preparatory step S1, which involves aligning S11 the donor substrate 1 with a component 5 to de deposited onto an acceptor substrate 7. Components 5 should be precisely aligned with the donor substrate 1, which means among other things that the orientation of the donor substrate 1 should be well matched to that of a component 5. Components 5 can then be firmly attached to the donor substrate 1 across its footprint with a uniform distribution of adhesive force. Once the donor substrate 1 and the component 5 are properly aligned, the method can move onto attaching S12 the component 5 to the donor substrate. Depending on the materials that the adhesive layers 43 of the release patches 4 are composed of, this attaching S12 may involve curing through UV exposure, heat or other means to achieve full bonding strength. Once the component 5 to be transferred is attached to the donor substrate 1, the method can move on to transferring the component 5 to the acceptor substrate 7. In order to ensure proper placement of the component 5 on the acceptor substrate 7, a step S2 of alignment is first performed. The method may thus first determine the location on the acceptor substrate 7 where the component 5 is to be deposited and subsequently position S21 the component 5 relative to the acceptor substrate. Afterward, a step S22 of optically aligning the light source with the donor substrate may be performed, such that upon illumination of the microlenses 3 the release patches will be properly exposed to optical energy from the light beam for triggering the release mechanism. It is advantageous to perform the optical alignment after the step of positioning S21 of the component 5 relative to the acceptor substrate, because in embodiments where the step S22 of optical alignment is performed first, additional positioning uncertainty could be introduced by moving the donor substrate and light source to their desired locations using separate motors or actuators. The method further comprises a step S3 of illuminating the microlenses 3. Each microlens 3 focuses the incoming light beam 6 into a narrower, intensified beam 6a directed onto the release patches 4 in their optical paths. As the focused beams hit the release patches 4, the optical energy causes the release of the components to the acceptor substrate. This may for example happen through a process of de-wetting. In that case, the optical energy may be absorbed by absorption layers 41, generating heat. This heat may then be transferred to a melting layer 42, causing it to reach its melting temperature and subsequently melt. The melting of this layer may disrupt the bond between an adhesive layer 43 and the melting layer 42. The component 5 is thus freed from the donor substrate 1 and transferred to the acceptor substrate 7 positioned below. The focusing mechanism of the microlenses 3 ensures that the transfer of components occurs only in the targeted areas where the light beams 6a are concentrated, allowing for controlled transfer processes of components of a broad range of sizes without the need for much more powerful light sources. As the microlenses 3 concentrate the initially broader light beam 6 into narrower, intensified focused beams 6a, the beams 6a may illuminate a substantial portion of the release patches' 4 covered areas. This may cause the concentrated beams 6a to distribute optical energy across a major part of the release patches 4, such as at least 50%, 80% or 90% of the area covered by the release patches. This allows for efficient absorption of the optical energy by the absorption layer 41, generating sufficient heat to melt the underlying melting layer 42.

Rather than a large component, a donor substrate 1 comprising a plurality of release patches 4 and microlenses 3 may also be used to simultaneously release a large number of components 5 to an acceptor substrate 7. This case is illustrated in figures 3A and 3B. Using a microlens array and a release patch array provides an advantageous means of rapidly transfering a large number of components. In some embodiments, some release patches may individually be attached with components, while at the same time other release patches may together be attached with a single, larger component. In such embodiments, the use of a microlens array and a release patch array further provides advantage, because it enables a rapid transfer of multiple components of various sizes and shapes. Some components may have more complex shapes. They may for example be oblong, L-shaped or T-shaped. The release patch array enables to attach such components to the donor substrate 1 at specific points of coverage, and thus removes the need to provide complexly shaped release patches, or more simply shaped release patches that are larger than the component to be transfered. The area to be illuminated is thereby reduced, improving energy efficiency.

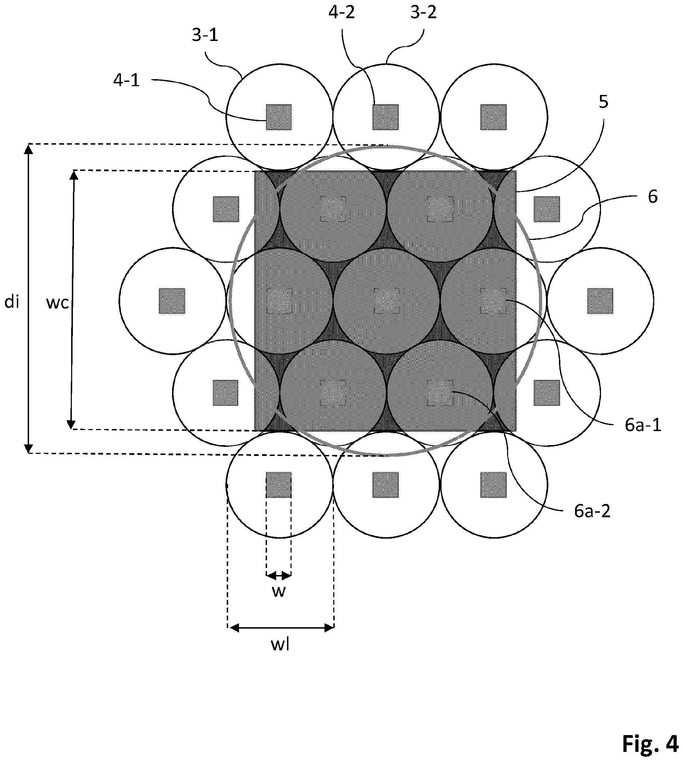

Figure 4 schematically illustrates how a microlens array may be arranged on the optically transparent carrier 2 of a donor substrate 1. In this figure, the microlenses 3 are plano-convex lenses attached to the optically transparent carrier 2 of a donor substrate 1 along their planar surfaces. The microlenses 3 are aligned with the release patches 4, such that the release patches 4 can receive the light beams 6a focused by the microlenses 3 from the light beam 6. Normally (contrary to the present invention), the component 5 would be attached to the donor substrate with a release stack 4 that covers the full surface of the component 5 (in this case a surface area of wc x wc). In that case, as the size of the component 5 increases, so does the required beam width di of the light beam 6 and therefore also the required optical power. However, in the present invention, the microlenses 3 focus the optical energy incident thereon onto the release patches 4. By condensing the optical power onto the release patches 4 from a larger area, the effectively required optical power for providing sufficient light beam fluence for triggering the release of the component 5 is significantly reduced. The component is thus able to be tranferred using a light source that consumes less energy. In this figure, the microlenses 3 are arranged in a heaxagonal lattice. This minimizes the unused space where optical energy from the light beam 6 is not focused onto a release patch 4. In other embodiments of the invention, the unused space may be reduced further by forming the planar surfaces of the microlenses as polygonal surfaces. For example, in this hexagonal lattice, the unused space would be completely eliminated by microlenses having planar surfaces that are shaped as hexagons. This embodiment further increases the energy efficiency of the invention by utilizing all of the optical power from the light beam 6. The radius of curvature of the convex surface of the microlenses 3 may be chosen in accordance with the size of the release patches 4, such that the focused beams have a final beam width suitable for triggering the release. The smaller the radius of curvature is, the stronger the curvature of the lens and therefore the smaller the width w of the release patches may be. With smaller release patches in turn comes a higher effective increase in the provided light beam fluence. The advantage gained by the use of a microlens array and a release patch array may thereby be tuned by varying the radius of curvature and the width wl of the microlenses according to case-specific requirements.

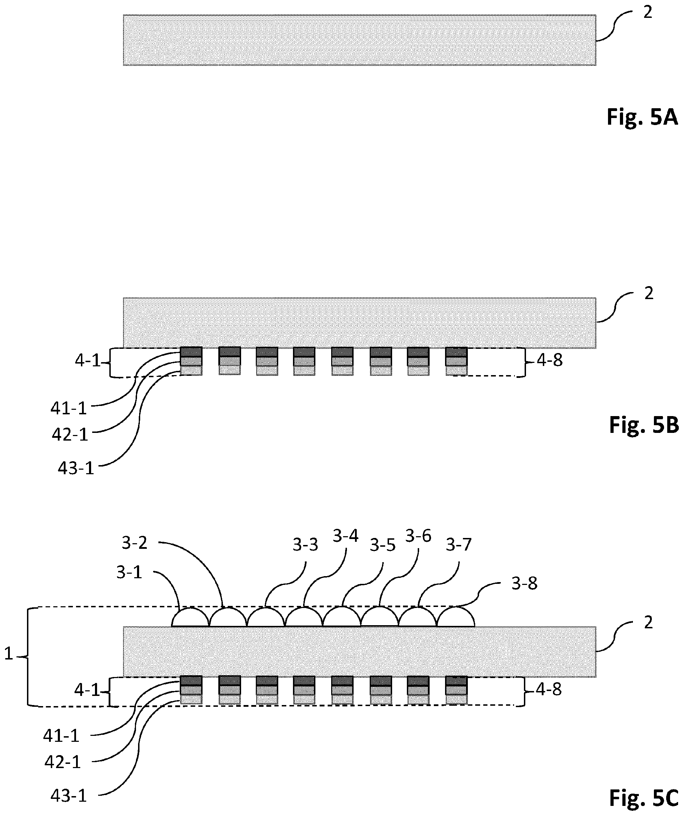

Figures 5A-5C schematically illustrate three points in a method in accordance with an embodiment of the third aspect of the invention. In figure 5A, an optically transparent carrier 2 is shown, as provided in the method. The transparent carrier 2 may serve as a base or foundation of the donor substrate 1 for carrying the other parts of the donor substrate. Accordingly, the method as shown in the figures further involves providing the transparent carrier 2 with a plurality of release patches 4-1 - 4-8 on spatially distributed spots of one side of the transparent carrier 2, as shown in figure 5B. Each of the release patches 4-1 - 4-8 may receive optical energy from a light beam. The release patches 4-1 - 4-8 may all together carry a same component 5 to be transferred until they are exposed to optical energy from the light beam, or in alternative embodiments may each carry a separate component. In yet further embodiments, a combination of these two cases may occur, wherein some release patches share a same component 5, while other release patches carry separate components. In the method according to the first aspect of the invention, the release patches 4-1 - 4-8 may receive optical energy from focused beams, meaning that the effective intensity of the light beam will be increased via focusing for each of the release patches 4-1 - 4-8. Accordingly, figure 5C shows the donor substrate 1 after having been provided, in accordance with the method, with microlenses 3-1 - 3-8 on the opposite side of the transparent carrier 2 with respect to the release patches 4-1 - 4-8. When used in a method according to the first aspect of the invention, the microlenses 3-1 - 3-8 may be illuminated with a light beam. Each of the microlenses 3-1 - 3-8 may then receive a portion of that light beam and focus its respective portion of the optical energy onto the release patches 4-1 - 4-8. The microlenses 3-1 - 3-8 focus the light beam and thereby effectively intensify the beam that is incident on the release patches 4-1 - 4-8. The combination of this effective intensification of the light beam with the spatial distribution of release patches 4-1 - 4-8 enables the light-induced transfer of components 5 to be performed using the method according to the first aspect of the invention, regardless of the size of the component 5, and with a light source that emits a lower amount of optical power and which can therefore be significantly less expensive. Alternatively, the donor substrate 1 manufactured in the method according the third aspect of the invention may be used to simultaneously transfer a large amount of small components that are attached to separate release patches 4-1-4-8.

The present invention has been described in terms of some specific embodiments thereof. It will be appreciated that the embodiments shown in the drawings and described herein are intended for illustrated purposes only and are not by any manner or means intended to be restrictive on the invention. It is believed that the operation and construction of the present invention will be apparent from the foregoing description and drawings appended thereto. It will be clear to the skilled person that the invention is not limited to any embodiment herein described and that modifications are possible which should be considered within the scope of the appended claims. Also kinematic inversions are considered inherently disclosed and to be within the scope of the invention. Moreover, any of the components and elements of the various embodiments disclosed may be combined or may be incorporated in other embodiments where considered necessary, desired or preferred, without departing from the scope of the invention as defined in the claims.

In the claims, any reference signs shall not be construed as limiting the claim. The term 'comprising' and 'including' when used in this description or the appended claims should not be construed in an exclusive or exhaustive sense but rather in an inclusive sense. Thus the expression 'comprising' as used herein does not exclude the presence of other elements or steps in addition to those listed in any claim. Furthermore, the words 'a' and 'an' shall not be construed as limited to 'only one', but instead are used to mean 'at least one', and do not exclude a plurality. Features that are not specifically or explicitly described or claimed may be additionally included in the structure of the invention within its scope. Any of the claimed or disclosed devices or portions thereof may be combined together or separated into further portions unless specifically stated otherwise, without departing from the claimed invention. Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. Additions, deletions, and modifications within the purview of the skilled person may generally be made without departing from the spirit and scope of the invention, as is determined by the claims. The invention may be practiced otherwise then as specifically described herein, and is only limited by the appended claims.

## Claims

1. Method of light-induced component transfer from a donor substrate to an acceptor substrate, the method comprising:
providing the donor substrate, wherein the donor substrate comprises an optically transparent carrier for transmitting a light beam, wherein the donor substrate is provided comprising a plurality of release patches on the optically transparent carrier; and
providing, using a light source, the light beam for illuminating the plurality of release patches through the optically transparent carrier;
wherein each release patch is configured for attaching a component to the donor substrate and for releasing the component to the acceptor substrate when the release patch is exposed to optical energy from the light beam,
wherein the plurality of release patches are spatially distributed on the transparent carrier, such as to form a release patch array, wherein the donor substrate is further provided comprising a plurality of microlenses at an opposite side of the transparent carrier with respect to the release patch array, the plurality of microlenses forming a microlens array for being illuminated with the light beam and for focusing the light beam onto the release patch array, such as to form a plurality of focused beams thereon,
wherein the method further comprises illuminating the microlens array with the light beam from the light source, wherein optical energy from the focused beams causes a release of attachment of the component, for releasing the component to the acceptor substrate.

2. Method according to claim 1, wherein each release patch is formed by a stack of layers comprising:
- an absorption layer for absorbing optical energy from the light beam, the absorption layer having a first melting temperature;
- a melting layer for being melted by heat from the absorption layer, the melting layer having a second melting temperature below the first melting temperature; and
- an adhesive layer for adhering the component to the melting layer, and for releasing the adhesion when the melting layer is in a molten state.

3. Method according to claim 1 or 2, wherein each focused beam has a second beam width smaller than a first beam width of the light beam used in the step of illuminating the microlens array,
wherein each release patch covers an area on the optically transparent carrier, and wherein a maximum width of the area covered by each release patch relates to the second beam widths such that each focused beam illuminates a major part of the area covered by one of the release patches.

4. Method according to claim 3, wherein the major part of the area covered by each release patch that is illuminated by one of the focused beams is at least 50%, preferably at least 80%, more preferably at least 90% of the area covered by each release patch.

5. Method according to any of the preceding claims, wherein, prior to illuminating the microlens array, at least one of:
- multiple release patches adhere a same component to the donor substrate; and
- multiple release patches adhere a different component to the donor substrate.

6. Method according to any of the preceding claims, wherein a planar surface of each microlens is one of a group comprising: circular surfaces, elliptical surfaces and polygonal surfaces.

7. Method according to any of the preceding claims, wherein each microlens is provided on the optically transparent carrier, such as to be positioned mutually adjacent to each other in one of: a hexagonal lattice, a triangular lattice, a square lattice, a rectangular lattice, a rhombic lattice, a pentagonal lattice, or an oblique lattice.

8. Donor substrate for use in a method according to any one or more of the preceding claims, for a light-induced component transfer to an acceptor substrate, wherein the donor substrate comprises an optically transparent carrier for transmitting a light beam, wherein the donor substrate comprises a plurality of release patches on the optically transparent carrier, wherein each release patch is configured for attaching a component to the donor substrate and for releasing the component to the acceptor substrate when the release patch is exposed to optical energy from the light beam,
wherein the plurality of release patches are spatially distributed on the optically transparent carrier, such as to form a release patch array, wherein the donor substrate further comprises a plurality of microlenses at an opposite side of the optically transparent carrier with respect to the release patch array, the plurality of microlenses forming a microlens array for being illuminated with the light beam and for focusing the light beam onto the release patch array, such as to form a plurality of focused beams thereon.

9. Donor substrate according to claim 8, wherein each release patch is formed by a stack of layers comprising:
- an absorption layer for absorbing optical energy from the light beam, the absorption layer having a first melting temperature;
- a melting layer for being melted by heat from the absorption layer, the melting layer having a second melting temperature below the first melting temperature; and
- an adhesive layer for adhering the component to the melting layer, and for releasing the adhesion when the melting layer is in a molten state.

10. Donor substrate according to claim 8 or 9, wherein each focused beam has a second beam width smaller than a first beam width of the light beam used in the step of illuminating the microlens array,
wherein each release patch covers an area on the optically transparent carrier, and wherein a maximum width of the area covered by each release patch relates to the second beam widths such that each focused beam illuminates a major part of the area covered by one of the release patches.

11. Donor substrate according to claim 10, wherein the major part of the area covered by each release patch that is illuminated by each respective focused beam is at least 50%, preferably at least 80%, more preferably at least 90% of the area covered by the release patch.

12. Donor substrate according to any of the claims 8-11, wherein, prior to illuminating the microlens array, at least one of:
- multiple release patches adhere a same component to the donor substrate; and
- multiple release patches adhere a different component to the donor substrate.

13. Donor substrate according to any of the claims 8-12, wherein a planar surface of each microlens is one of a group comprising: circular surfaces, elliptical surfaces and polygonal surfaces.

14. Donor substrate according to any of the claims 8-13, wherein each microlens is provided on the optically transparent carrier, such as to be positioned mutually adjacent to each other in one of: a hexagonal lattice, a triangular lattice, a square lattice, a rectangular lattice, a rhombic lattice, a pentagonal lattice, or an oblique lattice.

15. Method of manufacturing a donor substrate according to any one or more of the claims 8-14, wherein the method comprises:
- providing an optically transparent carrier for transmitting a light beam;
- spatially distributing a plurality of release patches on the optically transparent carrier, such as to form a release patch array, wherein each release patch is configured for attaching a component to the donor substrate and for releasing the component to an acceptor substrate when the release patch is exposed to optical energy from the light beam;
- providing an opposite side of the transparent carrier with respect to the release patch array with a plurality of microlenses, such as to form a microlens array for being illuminated with the light beam and for focusing the light beam onto the release patch array, such as to form a plurality of focused beams thereon.
